# EUROPEAN PATENT SPECIFICATION

(11) **EP 1 758 150 B1**
(45) Date of publication and mention of the grant of the patent: **12.10.2011**
(21) Application number: 06016703.8
(22) Date of filing: 10.08.2006
(51) Int. Cl.: H01L 21/02, H01L 21/316, H01L 23/31, B41J 2/16, H01L 27/10, H01L 41/22, H01L 27/115

(54) **Capacitor, method of manufacturing the same and its use**
Kondensator, dessen Herstellungsverfahren und seine Verwendung
Condensateur, son procédé de fabrication et son utilisation

(30) Priority: 25.08.2005 JP 2005244441
(43) Date of publication of application: 28.02.2007
(73) Proprietor: Seiko Epson Corporation, Shinjuku-ku Tokyo 163-0811 (JP)
(72) Inventor: Kobayashi, Daisuke, Suwa-shi Nagano-ken 392-8502 (JP); Nakayama, Masao, Suwa-shi Nagano-ken 392-8502 (JP); Kijima, Takeshi, Suwa-shi, Nagano-ken 392-8502 (JP)
(74) Representative: MERH-IP Matias Erny Reichl Hoffmann

(56) References cited:
- EP-A- 0 664 560
- US-A- 4 845 054
- US-A1- 2004 185 635
- US-A1- 2004 214 352
- US-A1- 2005 179 116
- US-B1- 6 207 590
- BOGART K H A ET AL: "PLASMA ENHANCED CHEMICAL VAPOR DEPOSITION OF SIO2 USING NOVEL ALKOXYSILANE PRECURSORS" JOURNAL OF VACUUM SCIENCE AND TECHNOLOGY: PART A, AVS /AIP, MELVILLE, NY, US, vol. 13, no. 2, 1 March 1995 (1995-03-01), pages 476-480, XP000498543 ISSN: 0734-2101

## Description

### BACKGROUND OF THE INVENTION

The present invention relates to a capacitor, a method of manufacturing the same, a method of manufacturing a ferroelectric memory device, a method of manufacturing an actuator, and a method of manufacturing a liquid jet head.

In recent years, a ferroelectric memory (FeRAM) has been expected to be a next-generation memory. The ferroelectric memory has advantages such as nonvolatility, high-speed operation, and low power consumption.

In the ferroelectric memory, the crystallization state of a dielectric film formed of a ferroelectric is one of the factors which determine the characteristics of the device. The manufacturing process of the ferroelectric memory includes forming an interlayer dielectric and a protective film. A large amount of hydrogen is produced in these steps. Since the dielectric film is formed of an oxide, the oxide may be reduced by hydrogen produced during the manufacturing process, whereby the characteristics of the ferroelectric memory may be adversely affected.

In order to prevent deterioration of the characteristics of the ferroelectric memory, the capacitor has been provided with reduction resistance by covering the dielectric film with a hydrogen barrier film such as an aluminum oxide film (see JP-A-2003-243625).

A multi-layer barrier film including silicon oxide films is disclosed in US-A1-2004-185635.

### SUMMARY

According to the invention, there is provided a method of manufacturing a capacitor, comprising:
forming a lower electrode on a substrate;
forming a dielectric film of a ferroelectric or a piezoelectric on the lower electrode;
forming an upper electrode on the dielectric film; and
forming a silicon oxide film,
by using trimethoxysilane,
wherein the step of forming the silicon oxide film includes:
forming a first silicon oxide film by single-frequency plasma chemical vapor deposition (CVD) so that at least the dielectric film and the upper electrode are covered with the first silicon oxide film; and
forming a second silicon oxide film by dual-frequency plasma CVD so that the first silicon oxide film is covered with the second silicon oxide film.

### BRIEF DESCRIPTION OF THE SEVERAL VIEWS OF THE DRAWING

FIG. 1 is a cross-sectional view schematically showing a manufacturing step of a capacitor according to a first example.
FIG. 2 is a cross-sectional view schematically showing another manufacturing step of the capacitor according to the first example.
FIG. 3 shows hysteresis characteristic measurement results before deposing a silicon oxide film.
FIG 4 shows hysteresis characteristic measurement results of an experimental example according to the first example.
FIG 5 shows hysteresis characteristic measurement results of the experimental example according to the first example.
FIG. 6 shows FT-IR analysis results of the experimental example according to the first example.
FIG 7 shows PCT results of the experimental example according to the first example.
FIG 8 shows water drop test results of the experimental example according to the first example.
FIG. 9 is a cross-sectional view schematically showing a manufacturing step of a capacitor according to a first embodiment.
FIG. 10 is a cross-sectional view schematically showing another manufacturing step of the capacitor according to the first embodiment.
FIG. 11 shows water drop test results of an experimental example according to the first embodiment.
FIG 12 is a plan view schematically showing a ferroelectric memory according to an example.
FIG. 13 is a cross-sectional view taken along the line XIII-XIII in FIG 12.
FIG. 14 is a cross-sectional view schematically showing a liquid jet head according to an example.
FIG 15 is an exploded perspective view of a liquid jet head according to an example.

### DETAILED DESCRIPTION OF THE EMBODIMENT

The invention may provide a method of manufacturing a capacitor which can reduce damage to a dielectric film, and a capacitor obtained by this method. The invention may also provide a method of manufacturing a ferroelectric memory device, a method of manufacturing an actuator, and a method of manufacturing a liquid jet head.

According to one embodiment of the invention, there is provided a method of manufacturing a capacitor, comprising:
forming a lower electrode on a substrate;
forming a dielectric film of a ferroelectric or a piezoelectric on the lower electrode;
forming an upper electrode on the dielectric film; and
forming a silicon oxide film so that at least the dielectric film is covered with the silicon oxide film,
the silicon oxide film being formed by using trimethoxysilane.

In this method of manufacturing a capacitor, the silicon oxide film is formed using trimethoxysilane (TMS). Production of hydrogen during the process is reduced by using TMS. Moreover, an excellent silicon oxide film can be obtained at a low temperature. Specifically, since the formation process of the silicon oxide film using TMS can be carried out at a low temperature with a small amount of hydrogen, diffusion of hydrogen into the dielectric film can be reduced. Therefore, an excellent silicon oxide film can be obtained by using TMS while reducing the process damage to the dielectric film due to reduction.

In this invention, the statement "a specific component (hereinafter called B) is formed on (or over) another specific component (hereinafter called A)" includes the case where the component B is formed directly on (or over) the component A and the case where the component B is formed on (or over) the component A through another component provided on the component A.

In this method of manufacturing a capacitor,
forming the silicon oxide film includes:
forming a first silicon oxide film by single-frequency plasma chemical vapor deposition (CVD) so that at least the dielectric film and the upper electrode are covered with the first silicon oxide film; and
forming a second silicon oxide film by dual-frequency plasma CVD so that the first silicon oxide film is covered with the second silicon oxide film.

According to one example of application of the invention, there is provided a method of manufacturing a ferroelectric memory device, comprising:
forming a lower electrode on a substrate;
forming a dielectric film of a ferroelectric on the lower electrode;
forming an upper electrode on the dielectric film;
forming a silicon oxide film so that at least the dielectric film is covered with the silicon oxide film; and
forming a control circuit section electrically connected to at least one of the upper electrode and the lower electrode,
the silicon oxide film being formed by using trimethoxysilane.

According to one embodiment of the invention, there is provided a method of manufacturing an actuator, comprising:
forming a lower electrode on an elastic plate;
forming a dielectric film of a piezoelectric on the lower electrode;
forming an upper electrode on the dielectric film; and
forming a silicon oxide film so that at least the dielectric film is covered with the silicon oxide film,
the silicon oxide film being formed by using trimethoxysilane.

According to one example of application of the invention, there is provided a method of manufacturing a liquid jet head, comprising:
forming an elastic plate on a substrate;
forming a lower electrode on the elastic plate;
forming a dielectric film of a piezoelectric on the lower electrode;
forming an upper electrode on the dielectric film;
forming a silicon oxide film so that at least the dielectric film is covered with the silicon oxide film;
forming a channel in the substrate; and
forming a nozzle plate having a nozzle communicating with the channel under the substrate,
the silicon oxide film being formed by using trimethoxysilane.

In this invention, the statement "the component B is formed under the component A" includes the case where the component B is formed directly under the component A and the case where the component B is formed under the component A through another component provided under the component A.

Examples not forming part of the invention and embodiments of the invention are described below with reference to the drawings.

### First example

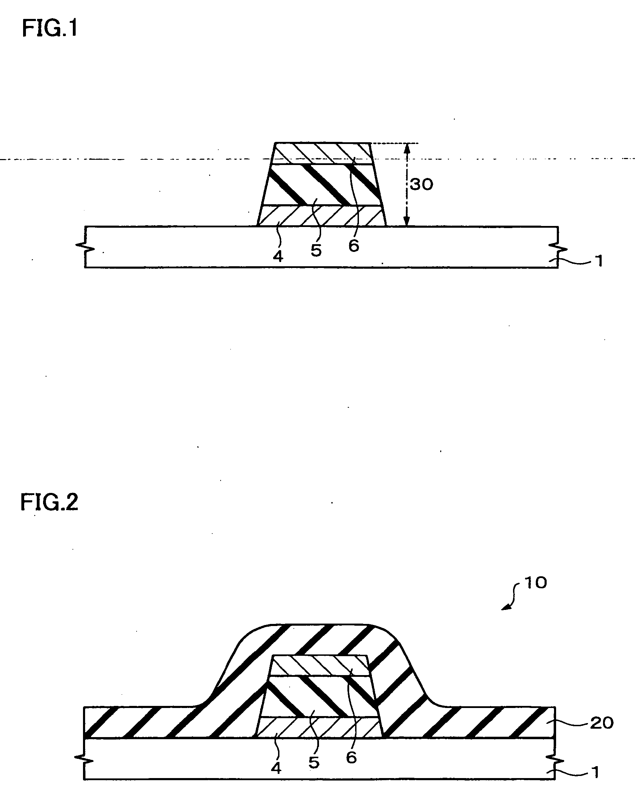

A method of manufacturing a capacitor according to a first example and a capacitor obtained by this method are described below. FIGS. 1 and 2 are cross-sectional views schematically showing manufacturing steps of the capacitor according to this embodiment.

A lower electrode 4, a dielectric film 5, and an upper electrode 6 are stacked on a substrate 1 in that order. As shown in FIG 1, the upper electrode 6, the dielectric film 5, and the lower electrode 4 are etched into a desired shape. This allows a columnar deposited product (hereinafter called "columnar portion") 30 formed of the lower electrode 4, the dielectric film 5, and the upper electrode 6 to be formed on the substrate 1.

The substrate 1 is not particularly limited. For example, a semiconductor substrate, a resin substrate, or the like may be arbitrarily used depending on the application. As the materials for the lower electrode 4 and the upper electrode 6, a high-melting-point metal such as Pt or Ir or an oxide of the high-melting-point metal may be used, for example. The lower electrode 4 and the upper electrode 6 may be formed by sputtering, deposition, or the like. The dielectric film 5 is formed of a ferroelectric or a piezoelectric. As the materials for the lower electrode 4 and the upper electrode 6, it is preferable to use a material which rarely reacts with the dielectric film 5 and allows an excellent dielectric film 5 to be formed. In more detail, Pt may be used for the lower electrode 4 and the upper electrode 6, and a ferroelectric film obtained by doping lead zirconate titanate containing Pb, Zr, and Ti as the constituent elements with Nb (hereinafter called "PZTN") may be used as the dielectric film 5. The dielectric film 5 may be formed by applying a sol-gel solution containing Pb, Zr, Ti, and Nb to the lower electrode 4 by spin coating or the like. The thickness of the lower electrode 4 may be 200 nm, the thickness of the dielectric film 5 may be 150 nm, and the thickness of the upper electrode 6 may be 100 nm, for example.

As shown in FIG. 2, a silicon oxide (SiO₂) film 20 is formed to cover the lower electrode 4, the dielectric film 5, and the upper electrode 6 (i.e. columnar portion 30). The silicon oxide film 20 is formed using trimethoxysilane (TMS). The silicon oxide film 20 may be formed to a thickness of 100 to 200 nm, for example.

The silicon oxide film 20 may be formed by chemical vapor deposition (CVD). For example, dual-frequency plasma CVD may be used in which radio frequencies (RF) are applied to the plasma source side and the bias side. As specific conditions, the plasma source side frequency and power may be respectively set at 27 MHz and 300 W, and the bias side frequency and power may be respectively set at 380 MHz and 300 W, for example. Single-frequency plasma CVD may also be used in which an RF is applied to only the plasma source side, for example. As specific conditions, the plasma source side frequency and power may be respectively set at 27 MHz and 300 W, for example. As examples of an oxidizing agent used for CVD, oxygen (O₂), dinitrogen oxide (N₂O), and the like can be given.

A heat treatment may be then performed, as required. This improves electrical characteristics. The heat treatment temperature may be set at 450°C, for example.

A capacitor 10 according to this embodiment may be manufactured by the above-described steps, as shown in FIG 2.

The capacitor 10 may be a stacked type capacitor as shown in FIG. 2, or may be a planar type capacitor. The capacitor 10 may be used as a ferroelectric capacitor using the dielectric film 5 formed of a ferroelectric, for example. The above description also applies to a second example described later.

An experimental example is given below.

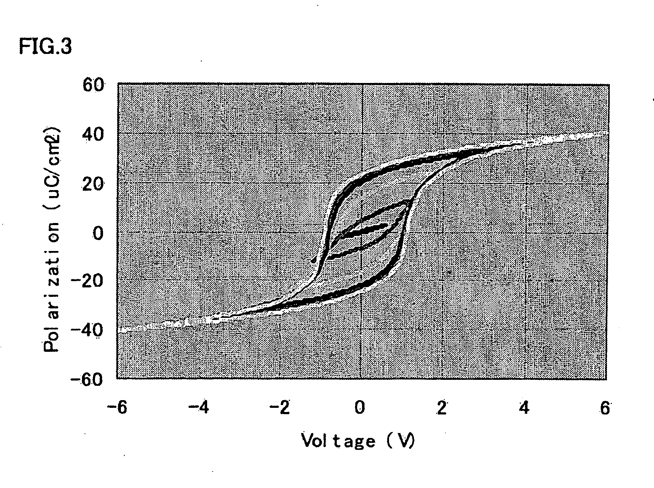

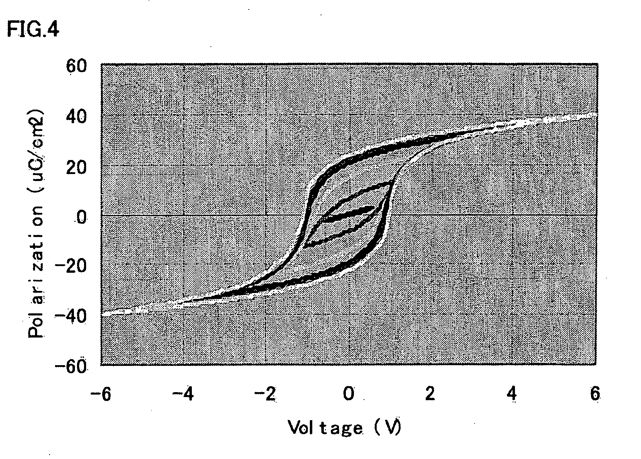

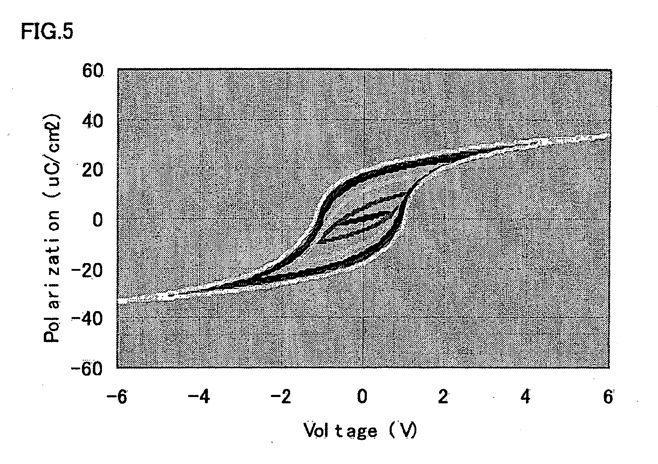

The hysteresis characteristics of the capacitor 10 obtained using the above-described manufacturing method were measured. FIG. 3 is a view showing the hysteresis characteristic measurement results before depositing the silicon oxide film 20. FIG. 4 is a view showing the hysteresis characteristic measurement results after deposing the silicon oxide film 20 by dual-frequency plasma CVD and performing heat treatment. FIG. 5 is a view showing the hysteresis characteristic measurement results after deposing the silicon oxide film 20 by single-frequency plasma CVD and performing heat treatment. In this experimental example, the silicon oxide film 20 was deposited at 300°C.

When depositing the silicon oxide film 20 by dual-frequency plasma CVD, the same hysteresis characteristics were obtained before depositing the silicon oxide film 20 (FIG 3) and after the heat treatment (FIG. 4). Accordingly, the hysteresis characteristics did not deteriorate. When deposing the silicon oxide film 20 by single-frequency plasma CVD, excellent hysteresis characteristics were obtained after the heat treatment, as shown in FIG 5.

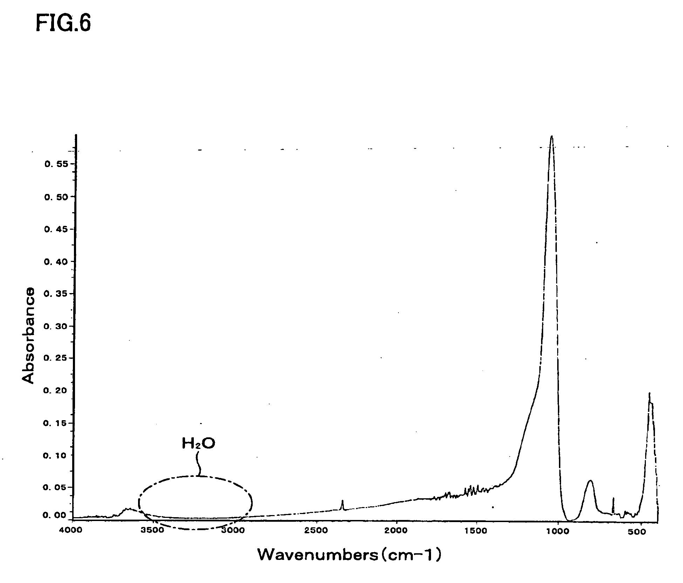

The water content of the silicon oxide film 20 was measured by Fourier transform infrared spectroscopy (FT-IR). FIG 6 is a view showing the FT-IR analysis results of the silicon oxide film 20 deposited by dual-frequency plasma CVD. In FIG. 6, the peak in the area (H₂O) enclosed by the dash-dotted line indicates the water content of the film.

As shown in FIG 6, water in the film was not observed when depositing the silicon oxide film 20 by dual-frequency plasma CVD. Therefore, it was confirmed that an excellent silicon oxide film 20 was formed.

The water (H₂O) barrier properties of the silicon oxide film 20 were investigated by performing a pressure cooker test (PCT). In more detail, the pressure cooker test was carried out as follows.

A phospho silicate glass (PSG) film was deposited on a silicon substrate. The peak of phosphorus (P) in the PSG film was determined by FT-IR. The silicon oxide film 20 was deposited on the PSG film using the above manufacturing method. An acceleration treatment was performed using an accelerated life test instrument. As the acceleration treatment conditions, the temperature was set at 117°C, the humidity was set at 100%, the pressure was set at 1.8 kg/cm², and the time was set at 0.5 to 6 hours. The peak of phosphorus (P) was again determined by FT-IR to determine the amount of change. The water (H₂O) permeability of the silicon oxide film 20 may be determined from the amount of change.

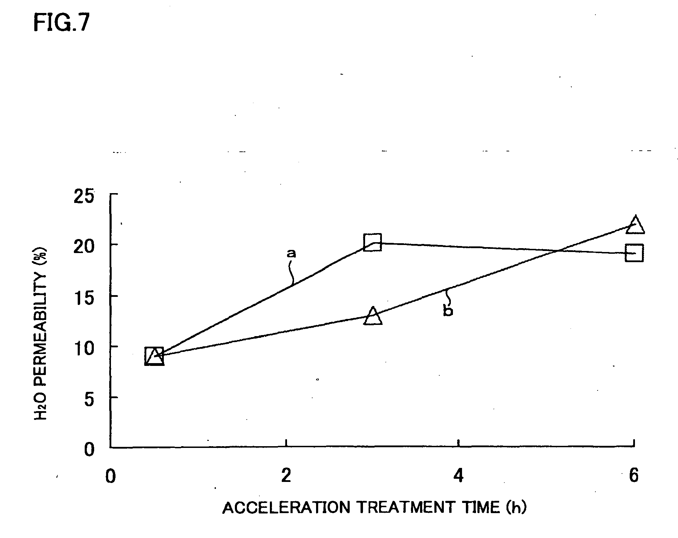

FIG. 7 is a view showing the PCT result, illustrating the relationship between the water permeability and the acceleration treatment time. The graph "a" in FIG 7 indicates the PCT results of the silicon oxide film 20 deposited by dual-frequency plasma CVD. N₂O was used as the oxidizing agent for dual-frequency plasma CVD. As indicated by the graph "a" in FIG. 7, the water permeability was 20% or less when depositing the silicon oxide film 20 by dual-frequency plasma CVD. Therefore, it was confirmed that the silicon oxide film 20 exhibited excellent water barrier properties. The graph b in FIG 7 is described later in a second example.

The insulating properties of the silicon oxide film 20 were investigated by performing a water drop test. In more detail, the water drop test was carried out as follows.

The capacitor 10 was formed using the above-described manufacturing method. In this experimental example, the silicon oxide film 20 was deposited at 350°C. Water was dripped on the silicon oxide film 20 of the capacitor 10. A probe was caused to come in contact with each of the upper electrode 6 and the water drops. A voltage was applied between the probes, and current flowing between the probes was measured. This allows measurement of a leakage current flowing through the silicon oxide film 20 so that the insulating properties of the silicon oxide film 20 can be determined.

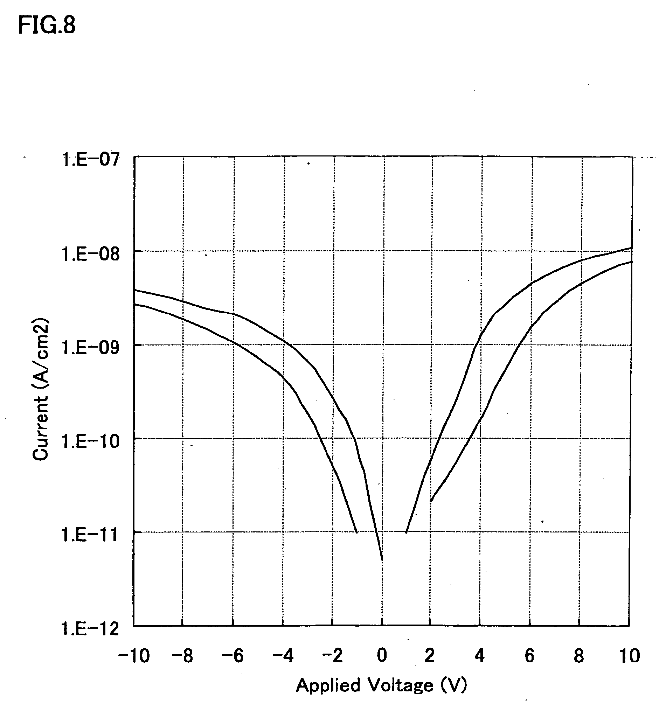

FIG. 8 is a view showing the water drop test results of the silicon oxide film 20 deposited by dual-frequency plasma CVD.

As shown in FIG. 8, the leakage current was 1×10⁻⁸ A/cm₂ or less when depositing the silicon oxide film 20 by dual-frequency plasma CVD. Therefore, it was confirmed that the silicon oxide film 20 exhibited excellent insulating properties.

The silicon oxide film 20 formed on the upper electrode 6 formed of platinum (Pt) was observed using an optical microscope to determine the presence or absence of separation. Separation was not observed when depositing the silicon oxide film 20 by single-frequency plasma CVD, but partial separation was observed when depositing the silicon oxide film 20 by dual-frequency plasma CVD.

In this example, the silicon oxide film 20 is formed using trimethoxysilane (TMS). The numbers of carbon atoms (C) and hydrogen atoms (H) of trimethoxysilane (TMS: (CH₃O)₃SiH) per molecule are about half of those of tetraethoxysilane (TEOS: (C₂H₅O)₄Si) which is generally used to form a silicon oxide film. Therefore, production of hydrogen during the CVD process is reduced by using TMS. Moreover, since TMS is easily decomposed in comparison with TEOS, an excellent silicon oxide film 20 can be obtained at a low temperature (room temperature to 350°C). Specifically, since the formation process of the silicon oxide film 20 using TMS can be carried out at a temperature lower than that of the formation process using TEOS (formation temperature: 400°C or more) with a smaller amount of hydrogen, diffusion of hydrogen into the dielectric film 5 can be reduced. Therefore, an excellent silicon oxide film 20 can be obtained by using TMS while reducing the process damage to the dielectric film 5 due to reduction. In particular, damage to the dielectric film 5 rarely occurs when using PZTN as the material for the dielectric film 5.

According to this example, since the process damage to the dielectric film 5 due to reduction can be reduced, as described above, a desired quality of the capacitor 10 can be ensured without forming a hydrogen barrier film such as an aluminum oxide film. An improvement in productivity and a reduction in production cost can be achieved by omitting formation of a hydrogen barrier film.

According to this example, the columnar portion 30 can be satisfactorily covered with (embedded in) the silicon oxide film 20 formed using TMS.

According to this example, the silicon oxide film 20 can be formed by dual-frequency plasma CVD. This prevents water from being mixed into the silicon oxide film 20, whereby an excellent silicon oxide film 20 can be formed. Moreover, a silicon oxide film 20 exhibiting excellent water barrier properties and excellent insulating properties can be formed. The above experimental example confirmed these advantages.

According to this example, the silicon oxide film 20 can be formed by single-frequency plasma CVD. This allows formation of a silicon oxide film 20 exhibiting excellent adhesion to the upper electrode 6.

### First Embodiment

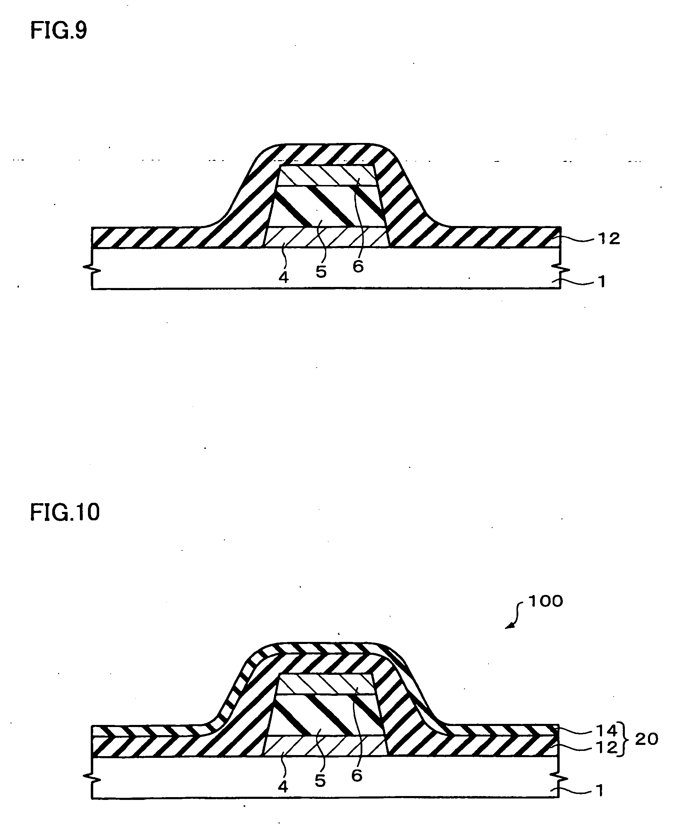

A method of manufacturing a capacitor according to a first embodiment and a capacitor obtained by this method are described below. FIGS. 9 and 10 are cross-sectional views schematically showing manufacturing steps of the capacitor according to this embodiment. The same sections as those of the capacitor 10 according to the first example are indicated by the same symbols. Detailed description of these sections is omitted.

As shown in FIG 1, the columnar portion 30 including the lower electrode 4, the dielectric film 5, and the upper electrode 6 is formed on the substrate 1. This step is the same as the above-described manufacturing step of the capacitor according to the first embodiment. Therefore, detailed description of this step is omitted.

As shown in FIG. 9, a first silicon oxide (SiO₂ film 12 is formed to cover the lower electrode 4, the dielectric film 5, and the upper electrode 6 (i.e. columnar portion 30). The first silicon oxide film 20 is formed using trimethoxysilane (TMS). The first silicon oxide film 20 may be formed to a thickness of 100 nm, for example.

The first silicon oxide film 12 is formed by single-frequency plasma CVD. As specific conditions, the plasma source side frequency and power may be respectively set at 27 MHz and 300 W, for example. As examples of an oxidizing agent used for CVD, oxygen (O₂), dinitrogen oxide (N₂O), and the like can be given.

As shown in FIG 10, a second silicon oxide (SiO₂) film 14 is formed to cover the first silicon oxide film 12. This allows formation of the silicon oxide film 20 including the first silicon oxide film 12 and the second silicon oxide film 14. The second silicon oxide film 14 is formed using trimethoxysilane (TMS). The second silicon oxide film 14 may be formed to a thickness of 30 nm, for example.

The second silicon oxide film 14 is formed by dual-frequency plasma CVD. As specific conditions, the plasma source side frequency and power may be respectively set at 27 MHz and 300 W, and the bias side frequency and power may be respectively set at 380 MHz and 300 W, for example. As examples of an oxidizing agent used for CVD, oxygen (O₂), dinitrogen oxide (N₂O), and the like can be given.

A heat treatment may be then performed, as required. This improves electrical characteristics. The heat treatment temperature may be set at 450°C, for example.

A capacitor 100 according to this embodiment may be manufactured by the above-described steps, as shown in FIG 10.

An experimental example is given below.

The water (H₂O) barrier properties of the silicon oxide film 20 were investigated by performing a pressure cooker test (PCT) in the same manner as in the experimental example of the first example.

The graph "b" in FIG 7 indicates the PCT results of the silicon oxide film 20. As indicated by the graph "b" in FIG. 7, the water permeability of the silicon oxide film 20 according to this experimental example was 22% or less. Therefore, it was confirmed that the silicon oxide film 20 exhibited excellent water barrier properties.

The insulating properties of the silicon oxide film 20 were investigated by performing a water drop test in the same manner as in the experimental example of the first embodiment.

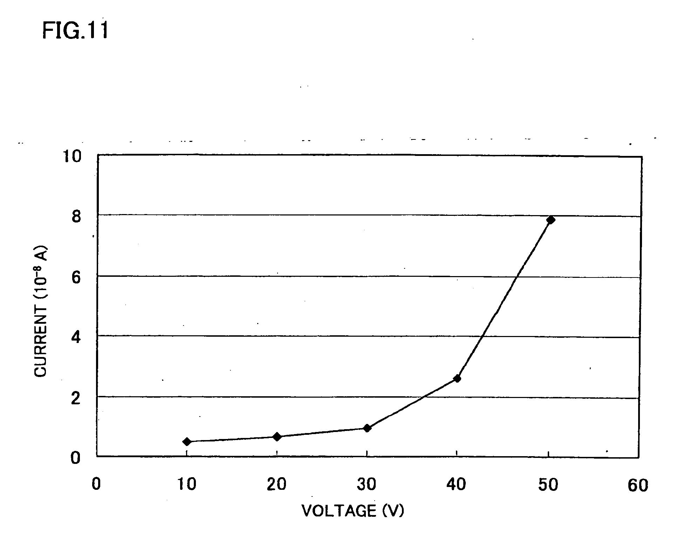

FIG. 11 is a view showing the water drop test results. As shown in FIG. 11, the leakage current was 1 × 10⁻⁸ A/cm₂ or less at an applied voltage of 30 V or less. Therefore, it was confirmed that the silicon oxide film 20 according to this embodiment exhibited excellent insulating properties.

The silicon oxide film 20 formed on the upper electrode 6 formed of platinum (Pt) was observed using an optical microscope to determine the presence or absence of separation. Separation of the silicon oxide film 20 was not observed after deposition and heat treatment. Therefore, it was confirmed that the silicon oxide film 20 exhibited excellent adhesion to the upper electrode 6. The heat treatment temperature was set at 450°C.

In this embodiment, the silicon oxide film 20 (i.e. first silicon oxide film 12 and second silicon oxide film 14) is formed using trimethoxysilane (TMS). Therefore, an excellent silicon oxide film 20 can be obtained while reducing the process damage to the dielectric film 5 due to reduction in the same manner as in the first embodiment. In particular, damage to the dielectric film 5 rarely occurs when using PZTN as the material for the dielectric film 5.

According to this embodiment, a desired quality of the capacitor 100 can be ensured without forming a hydrogen barrier film such as an aluminum oxide film in the same manner as in the first embodiment. An improvement in productivity and a reduction in production cost can be achieved by omitting formation of a hydrogen barrier film.

According to this embodiment, the first silicon oxide film 12 is formed on the upper electrode 6 by single-frequency plasma CVD. As described in the first example, the first silicon oxide film 12 formed by single-frequency plasma CVD exhibits excellent adhesion to the upper electrode 6. The second silicon oxide film 14 is formed on the first silicon oxide film 12 by dual-frequency plasma CVD to obtain the silicon oxide film 20. As described in the first example, the second silicon oxide film 14 formed by dual-frequency plasma CVD exhibits excellent water barrier properties and excellent insulating properties. According to this embodiment, the silicon oxide film 20 having a two-layer structure can be formed which exhibits excellent adhesion to the upper electrode 6, excellent water barrier properties, and excellent insulating properties. In other words, this embodiment allows provision of a capacitor 100 in which the adhesion of the first silicon oxide film 12 to the upper electrode 6 is higher than the adhesion of the second silicon oxide film 14 to the upper electrode 6. Moreover, this embodiment allows provision of a capacitor 100 in which the water barrier properties and the insulating properties of the second silicon oxide film 14 are higher than the water barrier properties and the insulating properties of the first silicon oxide film 12. The above experimental example confirmed these advantages.

### Second Example

An example of applying the capacitor described in the first embodiment and the method of manufacturing the same to a ferroelectric memory device and a method of manufacturing the same is described below.

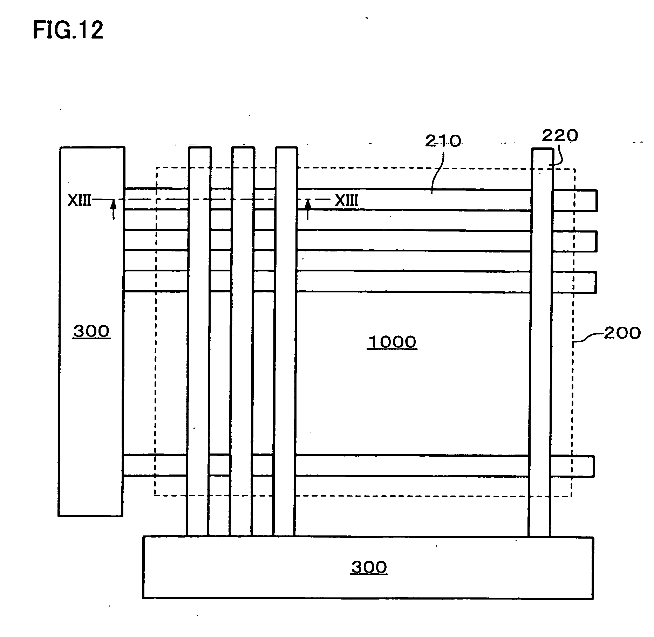

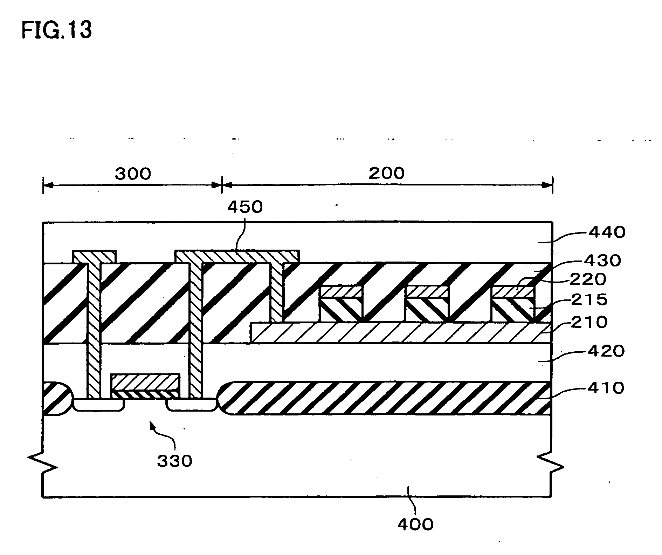

FIG. 12 is a view schematically showing a ferroelectric memory device 1000 according to this embodiment, and FIG 13 is a cross-sectional view along the line XIII-XIII in FIG. 12. These drawings illustrate a simple-matrix (cross-point) ferroelectric memory device.

As shown in FIG. 12, the ferroelectric memory device 1000 includes a memory cell array 200 and a control circuit section 300. The control circuit section 300 is disposed on a substrate 400 in a region differing from the memory cell array 200. In the memory cell array 200, row-select lower electrodes 210 (wordlines) and column-select upper electrodes 220 (bitlines) are arranged to intersect. In FIG 12, the wordlines and the bitlines are partially omitted.

As shown in FIG 13, a dielectric film 215 is disposed between a lower electrode 210 and an upper electrode 220. In the memory cell array 200, a memory cell functioning as a ferroelectric capacitor is formed in the intersecting region of the lower electrode 210 and the upper electrode 220. It suffices that the dielectric film 215 be disposed between the lower electrode 210 and the upper electrode 220 at least in the region in which the lower electrode 210 intersects the upper electrode 220. In the ferroelectric memory device 1000, a silicon oxide film 430 is formed to cover the lower electrode 210, the dielectric film 215, and the upper electrode 220. An insulating protective layer 440 is formed on the silicon oxide film 430 to cover an interconnect layer 450.

The control circuit section 300 includes circuits for selectively writing information into or reading information from the memory cell array 200. As shown in FIG. 13, the control circuit section 300 includes a MOS transistor 330 formed on the substrate 400. The MOS transistor 330 is isolated from other elements (not shown) by an element isolation region 410. An interlayer dielectric 420 is formed on the substrate 400 on which the MOS transistor 330 is formed. The control circuit section 300 is electrically connected with the memory cell array 200 through an interconnect layer 450. The control circuit section 300 is electrically connected with at least one of the upper electrode 220 and the lower electrode 210.

In the method of manufacturing the ferroelectric memory device 1000, the lower electrode 210, dielectric film 215, upper electrode 220, and silicon oxide film 430 are formed using the manufacturing method for the lower electrode 4, dielectric film 5, upper electrode 6, and silicon oxide film 20 according to the first or second embodiment. The method of manufacturing the ferroelectric memory device 1000 includes forming the control circuit section 300. The control circuit section 300 is formed using a known method.

The above example illustrates the simple-matrix (cross-point) ferroelectric memory device and the method of manufacturing the same. Note that the ferroelectric memory device and the method of manufacturing the same according to this embodiment may also be applied to ferroelectric memory devices using various cell methods, such as a 1T1C ferroelectric memory device and a 2T2C ferroelectric memory device, and a method of manufacturing the same.

According to this example, an excellent silicon oxide film 430 can be obtained while reducing the process damage to the dielectric film 215 due to reduction in the same manner as in the first and second embodiments. This improves the quality of the ferroelectric memory device 1000.

According to this example, a silicon oxide film 430 exhibiting excellent covering (embedding) properties can be formed in the same manner as in the first and second embodiments. According to this example, the lower electrode 210, the dielectric film 215, and the upper electrode 220 can be satisfactorily covered with (embedded in) the silicon oxide film 430 formed using TMS. In particular, it is effective to form a silicon oxide film 430 exhibiting excellent covering properties when a number of memory cells are highly integrated in a simple-matrix (cross-point) ferroelectric memory device.

### Third Example

An example of applying the capacitor described in the first embodiment and the method of manufacturing the capacitor to an actuator and a method of manufacturing the actuator and a liquid jet head and a method of manufacturing the liquid jet head is described below.

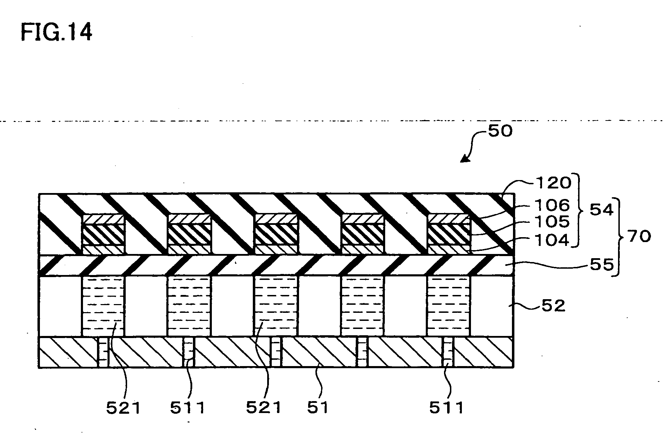

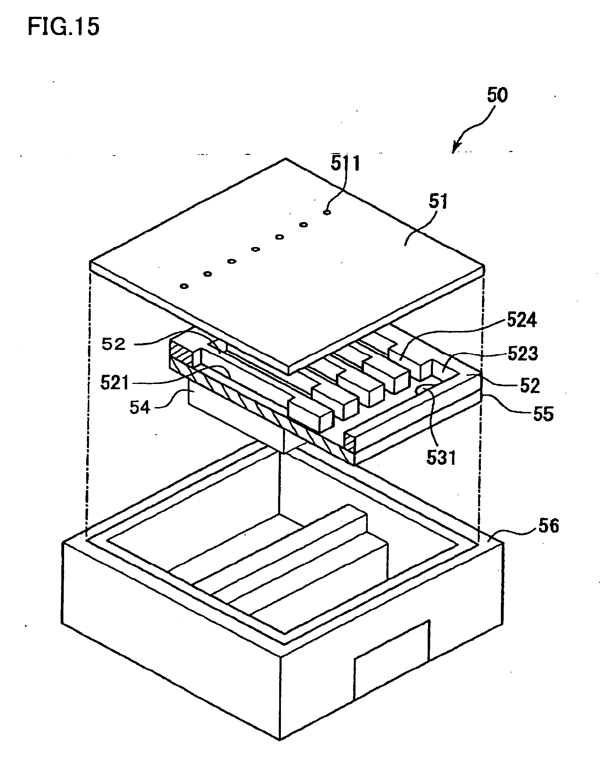

FIG. 14 is a view schematically showing a liquid jet head 50 according to this embodiment, and FIG. 15 is an exploded perspective view of the liquid jet head 50 according to this embodiment. FIG. 15 shows a state in which the liquid jet head 50 is reversed in the vertical direction.

As shown in FIG. 14, the liquid jet head 50 includes a nozzle plate 51, a substrate 52, and an actuator 70. The actuator 70 includes an elastic plate 55 formed on the substrate 52 and a piezoelectric section (vibration source) 54 formed on the elastic plate 55. The piezoelectric section 54 includes a lower electrode 104, a dielectric film 105 formed of a piezoelectric, an upper electrode 106, and a silicon oxide film 120. In FIG 15, illustration of each layer of the piezoelectric section 54 is omitted.

As shown in FIG. 15, the liquid jet head 50 further includes a base 56. The nozzle plate 51, the substrate 52, the elastic plate 55, and the piezoelectric section 54 are placed in the base 56. The base 56 is formed of a resin material, a metal material, or the like.

The nozzle plate 51 is formed of a stainless steel rolled plate or the like. A number of nozzles 511 for ejecting liquid droplets are formed in the nozzle plate 51 in a row. The substrate 52 is secured to the nozzle plate 51. The substrate 52 divides the space between the nozzle plate 51 and the elastic plate 55 to form a reservoir 523, a supply port 524, and a plurality of channels 521. The reservoir 523 temporarily stores liquid supplied from a liquid cartridge (not shown). The liquid is supplied to each channel 521 from the reservoir 523 through the supply port 524.

As shown in FIGS. 14 and 15, the channel 521 is disposed corresponding to each nozzle 511. The nozzle 511 communicates with the channel 521. The volume of the channel 521 can be changed due to vibration of the elastic plate 55. The liquid is ejected from the channel 521 due to a change in volume.

As shown in FIG. 15, a through-hole 531 is formed through the elastic plate 55 in the thickness direction at a specific position of the elastic plate 55. The liquid is supplied to the reservoir 523 from the liquid cartridge through the through-hole 531.

The piezoelectric section 54 is electrically connected with a piezoelectric device driver circuit (not shown), and is actuated (vibrate or deformed) based on a signal from the piezoelectric device driver circuit. The elastic plate 55 vibrates (deflects) due to vibration (deflection) of the piezoelectric section 54, and functions to momentarily increase the pressure inside the channel 521.

In the method of manufacturing the actuator 70 and the method of manufacturing the liquid jet head 50, the lower electrode 104, dielectric film 105, upper electrode 106, and silicon oxide film 120 are formed using the manufacturing method for the lower electrode 4, dielectric film 5, upper electrode 6, and silicon oxide film 20 according to the first or second embodiment. The method of manufacturing the liquid jet head 50 includes forming the elastic plate 55 on the substrate 52, forming the channel 521 in the substrate 52, and forming the nozzle plate 51 under the substrate 52. The elastic plate 55, the channel 521, and the nozzle plate 51 are formed using a known method.

According to this example, an excellent silicon oxide film 120 can be obtained while reducing the process damage to the dielectric film 105 due to reduction in the same manner as in the first and second embodiments. This improves the quality of the actuator 70 and the liquid jet head 50.

According to this example, since the process damage to the dielectric film 105 due to reduction can be reduced, as described above, a desired quality of the actuator 70 and the liquid jet head 50 can be ensured without forming a hydrogen barrier film such as an aluminum oxide film. The amount of displacement of the piezoelectric section 54 during operation can be increased by omitting formation of a hydrogen barrier film such as an aluminum oxide film having a hardness higher than that of the silicon oxide film 120. Therefore, this example allows provision of an actuator 70 and a liquid jet head 50 exhibiting excellent characteristics.

## Claims

1. A method of manufacturing a capacitor, comprising:
forming a lower electrode (4) on a substrate (1),
forming a dielectric film (5) of a ferroelectric or a piezoelectric on the lower electrode;
forming an upper electrode (6) on the dielectric film; and
forming a silicon oxide film (20) by using trimethoxysilane, **characterized in that** the step of forming the silicon oxide film includes:
forming a first silicon oxide film (12) by single-frequency plasma chemical vapor deposition (CVD) so that at least the dielectric film and the upper electrode are covered with the first silicon oxide film; and
forming a second silicon oxide film (14) by dual-frequency plasma CVD so that the first silicon oxide film is covered with the second silicon oxide film.

## Patentansprüche

1. Verfahren zur Herstellung eines Kondensators, das aufweist:
Bilden einer unteren Elektrode (4) auf einem Substrat (1);
Bilden eines dielektrischen Films (5) aus einem Ferroelektrikum oder einer Piezoelektrizität auf der unteren Elektrode;
Bilden einer oberen Elektrode (6) auf dem dielektrischen Film; und
Bilden eines Siliziumoxidfilms (20) unter Verwendung von Trimethoxysilan,
**dadurch gekennzeichnet, dass**
der Schritt des Bildens des Siliziumoxidfilms umfasst:
Bilden eines ersten Siliziumoxidfilms (18) durch Einzelfrequenz-Plasma-CVD(chemical vapor deposition - chemische Gasphasenabscheidung), so dass zumindest der dielektrische Film und die obere Elektrode mit dem ersten Siliziumoxidfilm bedeckt sind; und
Bilden eines zweiten Siliziumoxidfilms (14) durch Dualfrequenz-Plasma-CVD, so dass der erste Siliziumoxidfilm mit dem zweiten Siliziumoxidfilm bedeckt ist.

## Revendications

1. Procédé de fabrication d'un condensateur, dans lequel
on forme une électrode (4) inférieure sur un substrat (1) ;
on forme un film (5) diélectrique en un matériau ferroélectrique ou piézoélectrique sur l'électrode inférieure ;
on forme une électrode (6) supérieure sur le film diélectrique ; et
on forme un film (20) d'oxyde de silicium en utilisant du triméthoxysilane , **caractérisé en ce que**
le stade de formation du film d'oxyde de silicium comprend :
la formation d'un premier film (12) d'oxyde de silicium par dépôt chimique en phase vapeur à plasma à fréquence unique (CVD), de manière à ce qu'au moins le film diélectrique et l'électrode supérieure soient recouverts du premier film d'oxyde de silicium ; et
la formation d'un deuxième film (14) d'oxyde de silicium par CVD à plasma à fréquence dual, de manière à ce que le premier film d'oxyde de silicium soit recouvert du deuxième film d'oxyde de silicium.
